(19) **Europäisches Patentamt / European Patent Office / Office européen des brevets**

(11) **EP 2 979 633 A1**

(12) # EUROPEAN PATENT APPLICATION

published in accordance with Art. 153(4) EPC

(43) Date of publication:
03.02.2016 Bulletin 2016/05

(51) Int Cl.:
*A61B 5/055* [(2006.01)]        *G01R 33/56* [(2006.01)]

(21) Application number: 13880549.4

(86) International application number:
**PCT/CN2013/073455**

(22) Date of filing: 29.03.2013

(87) International publication number:
**WO 2014/153775 (02.10.2014 Gazette 2014/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Shenzhen Institute of Advanced Technology**
**Chinese Academy of Sciences**
**Shenzhen, Guangdong 518055 (CN)**

(72) Inventors:
• **CHUNG, Yiu-Cho**
**Shenzhen**
**Guangdong 518055 (CN)**

• **ZHU, Yanjie**
**Shenzhen**
**Guangdong 518055 (CN)**
• **LIU, Xin**
**Shenzhen**
**Guangdong 518055 (CN)**
• **ZHENG, Hairong**
**Shenzhen**
**Guangdong 518055 (CN)**

(74) Representative: **Gibson, Mark**
**Sagittarius IP**
**Three Globeside**
**Fieldhouse Lane**
**Marlow, Buckinghamshire SL7 1HZ (GB)**

(54) **FAST MAGNETIC RESONANCE IMAGING METHOD AND SYSTEM**

(57) A fast magnetic resonance imaging method and system, the method comprising: applying a periodic radio-frequency pulse train to drive the magnetization vector of an imaging volume into a steady state (102); acquiring a free induction decay (FID) signal and an echo signal alternately in a steady-state free precession sequence (104); conducting an FID signal imaging and a T2-weighted imaging (106). Alternate acquisition of the FID signal and the echo signal in the steady-state free precession sequence effectively increases the signal-to-noise ratio (SNR) of the acquired signals and reduces the sensitivity of the sequence to motions.

Fig. 1

EP 2 979 633 A1

**Description**

**Technical Field**

The present application relates generally to the technology of magnetic resonance imaging and more particularly to a method and system for fast magnetic resonance imaging.

**Background**

During the process of magnetic resonance imaging, if a radio-frequency pulse is applied periodically, wherein de-phased angles in each cycle are the same, a steady-state free precession sequence may be formed. If the duration of the cycle is shorter than the relaxation time T2, the transverse magnetization vector may not disappear completely at the end of the cycle. It may remain in the next cycle, forming a coherent steady-state signal. Since a high signal-to-noise ratio (SNR) may be obtained for the coherent steady-state signal when a short repetition time is used, the technique of generating coherent steady-state signal is an important branch of fast magnetic resonance imaging sequence technology. So far, the main coherent steady-state sequences include balanced steady-state free precession sequence (true FISP from Siemens, FIESTA from GE), double echo steady-state sequence (DESS of Siemens), etc., to name a few.

Within the repetition time (TR) of a coherent steady-state free precession sequence, the transverse magnetization vector consists of two high components, one being a transverse magnetization vector formed by the flip of longitudinal magnetization vector right after the excitation of the radio-frequency pulse, denoted as $S^+$; the other being a high signal formed by the re-phasing of residual magnetization vector being excited by the radio-frequency pulse with its accumulated phase from dispersion to refocusing that exists before the next radio-frequency pulse arrives, which is denoted as $S^-$. A completely symmetric gradient waveform is utilized by the true FISP sequence to acquire a signal that is a complete superposition of the signals $S^+$ and $S^-$, and gives a high SNR. However, the signal is sensitive to the magnetic field inhomogeneity. As the repetition time (TR) increases, banding artifacts would appear. The banding artifacts would deteriorate as magnetic field inhomogeneity increases, resulting in inferior image quality. In the double echo steady-state sequence, the gradient echo signals formed by the $S^+$ and $S^-$ within a single TR are acquired separately to obtain an FID (sometimes called FISP-FID: Fast Imaging with Steady Precession, Free Induction Decay) signal and an echo signal (FISP-echo) respectively. However, within a single period of TR, the two signals not only need to be acquired, but also need to be separated completely. Thus, TR will be long, imaging time increases, while the SNR decreases due to the increased TR. Moreover due to the coexistence of the $S^+$ and $S^-$ in the same TR, the two signals need to be separated by applying a gradient crusher appropriately, otherwise, mutual interference will result in artifacts in the image.

**Summary**

In the present application, one technical problem to be solved is to provide a fast magnetic resonance imaging method with good image quality and high SNR while overcoming deficiencies in the prior art.

Another problem to be solved in the present application is to provide a fast magnetic resonance imaging system based on the above method.

The present application solves the technical problems by the technical solutions below:

A fast magnetic resonance imaging method that comprise the following:

Applying a periodic radio-frequency pulse train to enable the magnetization vector of an imaging area to reach a steady state;
Acquiring an FID signal and an echo signal alternately (i.e., FID in the odd TR cycles and echo signal in the even TR cycles) in a steady-state free precession sequence;
Conducting FID signal imaging and T2-weighted imaging.

According to one embodiment of the present application, alternate acquisition of the FID signal and the echo signal in the steady-state free precession sequence is achieved by removing part of a compensation gradient from, or adding a gradient crusher into a balanced steady-state free precession sequence.

According to one embodiment of the present application, removing the part of the compensation gradient from the balanced steady-state free precession sequence comprises: removing the compensation gradient before the next radio-frequency pulse when acquiring the FID signal; and removing the compensation gradient after the radio-frequency pulse when acquiring the echo signal.

According to one embodiment of the present application, removing the part of the compensation gradient from the balanced steady-state free precession sequence comprises: removing the compensation gradient along the slice selection direction or removing the compensation gradient along the frequency encoding direction in the balanced steady-state free precession sequence.

According to one embodiment of the present application, the adding of the gradient crusher into the balanced steady-state free precession sequence comprises adding the gradient crusher along the phase encoding direction.

A fast magnetic resonance imaging system described here comprises a fast imaging module, which is configured to apply a periodic radio-frequency pulse train to drive the magnetization vector of an imaging volume into steady state; acquire an FID signal and an echo signal alternately from the steady-state signal; and conduct FID signal imaging and a T2-weighted imaging.

According to one embodiment of the present application, the fast imaging module is further configured to remove a part of a compensation gradient from, or add a gradient crusher into a balanced steady-state free precession sequence, to acquire the FID signal and the echo signal alternately in the steady-state free precession sequence.

According to one embodiment of the present application, the fast imaging module is further configured to remove the compensation gradient before the next radio-frequency pulse when acquiring the FID signal and remove the compensation gradient after the radio-frequency pulse when acquiring the echo signal.

According to one embodiment of the present application, the fast imaging module is further configured to remove the compensation gradient along the slice selection direction or remove the compensation gradient along the frequency encoding direction in the balanced steady-state free precession sequence.

According to one embodiment of the present application, the fast imaging module is further configured to add a gradient crusher along the phase encoding direction.

Due to the adoption of above technical solutions, the beneficial effects of the present application are:

(1) According to some embodiments of the present application, due to the alternate acquisition of FID signal and echo signal in a steady-state free precession sequence, the SNR of the acquired induction decay signal is increased effectively.

(2) According to some embodiments of the present application, due to the alternate acquisition of FID signal and echo signal in a steady-state free precession sequence, the obtained images are fully registered, and would not need any registration during post processing.

(3) According to some embodiments of the present application, the alternate acquisition of the FID signal and the echo signal is adopted, which are similar to an induction decay signal and a T2-weighted signal in the steady-state precession sequence, the banding artifacts may be eliminated.


**Brief Description of Drawings**

Fig. 1 is a flow chart illustrating a method for fast magnetic resonance imaging according to one embodiment of the present application;

Fig. 2 is a time sequence diagram of the alternate steady-state free precession sequence according to one embodiment of the present application;

Fig. 3 is a graph showing how FISP_FID signal and FISP_echo signal vary with the repetition time according to one embodiment of the present application;

Fig. 4 is a graph showing how FISP_FID signal and FISP_echo signal change with the flip angles of the radio-frequency pulse according to one embodiment of the present application;

Fig. 5 is a time sequence diagram illustrating the balanced steady-state free precession sequence in prior art;

Fig. 6 is a time sequence diagram illustrating the removal of a compensation gradient along the slice selection direction according to another embodiment of the present application;

Fig. 7 is a time sequence diagram illustrating the removal of a compensation gradient along the frequency encoding direction according to another embodiment of the present application;

Fig. 8 is a time sequence diagram illustrating the addition of a gradient crusher along the phase encoding direction according to another embodiment of the present application;

Fig. 9 is a block diagram illustrating the system architecture for a fast magnetic resonance imaging according to one embodiment of the present application.


**Detailed Description**

The detailed description of the present application will be described clearly and completely in conjunction with the exemplary embodiments and accompanying drawings.

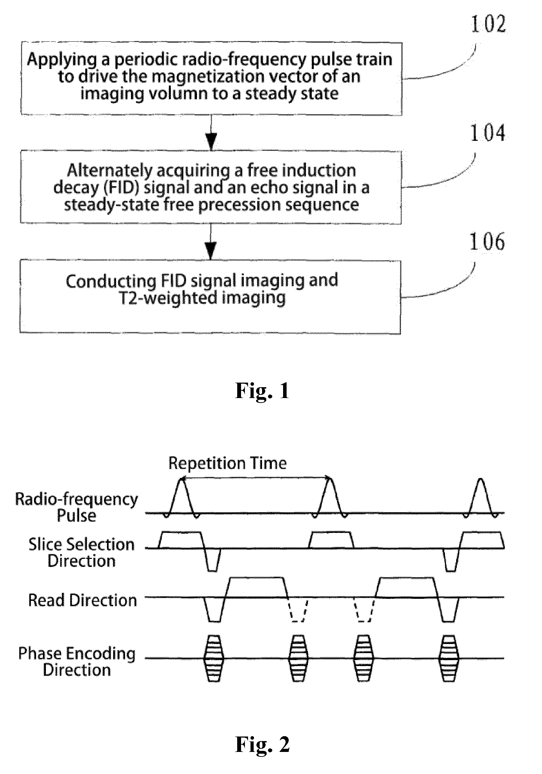

**Fig. 1** illustrates a flow chart of the fast magnetic resonance imaging method according to one embodiment of the present application, which includes:

Step **102**: applying a periodic radio-frequency pulse train to drive the magnetization vector of an imaging area into steady state;
Step **104**: acquiring an FID signal and an echo signal alternately in a steady-state free precession sequence;
Step **106**: conducting an FID signal imaging and a T2-weighted imaging.

According to this embodiment, a periodic radio-frequency pulse train is applied to drive the magnetization of an imaging area into steady state. These two signals are then acquired and conduct an FID signal imaging and a T2-weighted imaging by acquiring an FID signal and an echo signal alternately in a steady-state free precession sequence. The sequence may have a basic waveform as shown in **Fig. 2** if the waveform is depicted in a Cartesian coordinate.

As shown in the time sequence diagram of **Fig. 2,** by using radio-frequency pulses with identical TR and the same de-phased angles generated by additional gradient in every cycle, the requirements to generate steady-state coherent signals are satisfied. Thus, the magnetization vector may enter into a steady-state after certain number of excitation cycles. Based on the balanced steady-state free precession sequence, some of the compensation gradient are removed to acquire an FID signal and an echo signal alternately. As shown in **Fig. 2,** the compensation gradient is removed before the next radio-frequency pulse when acquiring an FID signal and the dephasing gradient is removed after the radio-frequency pulse when acquiring an echo signal, which is similar to the role of a gradient crusher. The gradient crusher may also be added along the frequency encoding direction (shown as the broken lines in **Fig. 2**), the phase encoding direction, or any combination of the three directions. The axis of the gradient crusher may affect the sensitivity of blood flow along its direction, but the added gradient crusher need to guarantee that the dephased angles of each pixel are more than $2\pi$ The time in which the gradient crusher is applied may vary with the axis where the gradient crusher is applied along, which may affect TR, and it should be determined according to the practical scenario in specific applications.

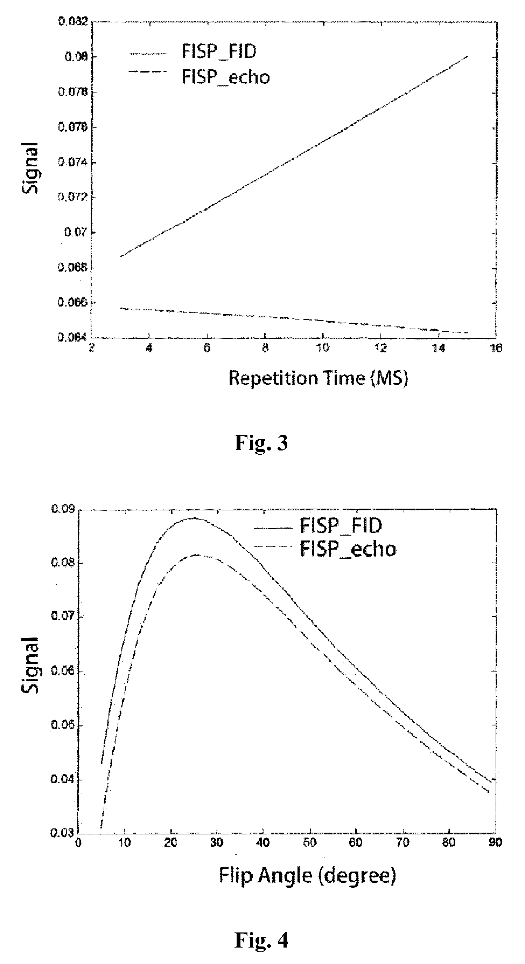

It's suggested by simulations that **Fig. 3** shows that TR and flip angles are the key factors affecting intensity and contrast of the two signals (FID and echo). The intensity of the FID signal increases as TR increases, whereas the intensity of the echo signal decreases as TR increases since the echo signal has a T2-weighted component. The contrast of the sequence for tissues with different T1 and T2 values varies with the variation of the degree of flip angles. This imaging technology may be used for the estimation of the parameter T2, imaging of blood flow etc. Detailed parameters may be setup based on need in practical applications.

The acquisition of an FID signal and an echo signal alternately in a steady-state free precession sequence disclosed herein may be appropriate for use in two dimensional (2D) and three dimensional (3D) imaging, and may also be applicable to various sampling strategies such as Cartesian sampling, spiral sampling, radial sampling or other K-space sampling methods.

FISP_FID(S$^+$) signal and FISP_echo(S$^-$) signal may be expressed, respectively, as:

$$S_0^+ = \int_{\theta 1}^{\theta 2} Q E_2' \sin \alpha \, (1 - E_2 \exp(-i\beta)) d\beta$$

$$S_0^- = \int_{\theta 1}^{\theta 2} Q E_2' \sin \alpha \, (\exp(-i\beta) - E_2) d\beta$$

Wherein,

$$Q = \frac{1 - E_1}{1 - E_1 \cos \alpha - (E_1 - \cos \alpha)E_2^2 + E_2(E_1 - 1)(1 + \cos \alpha) \cos \beta}$$

$$E_1 = \exp(-TR/T_1), \ E_2 = \exp(-TR/T_2), \ E_2' = \exp(-TE/T_2),$$

$\alpha$ is the flip angle of radio-frequency pulse,

β is the polarization angle of the magnetization within TR,

The integral of β is in the range of [0, 2π], that is $\theta_2 = \theta_1 + 2\pi$.

In the simulation, when T1=1000 ms, T2=80 ms, and α=50°, the curve of FISP_FID(S⁺) and FISP_echo(S⁻) signal versus TR is as shown in **Fig. 3**; when T1=1000 ms, T2=80 ms, TR=4 ms, and TE=2 ms, the curve of FISP_FID(S⁺) and FISP_echo(S⁻) signal versus flip angles of radio-frequency pulse is as shown in **Fig. 4**.

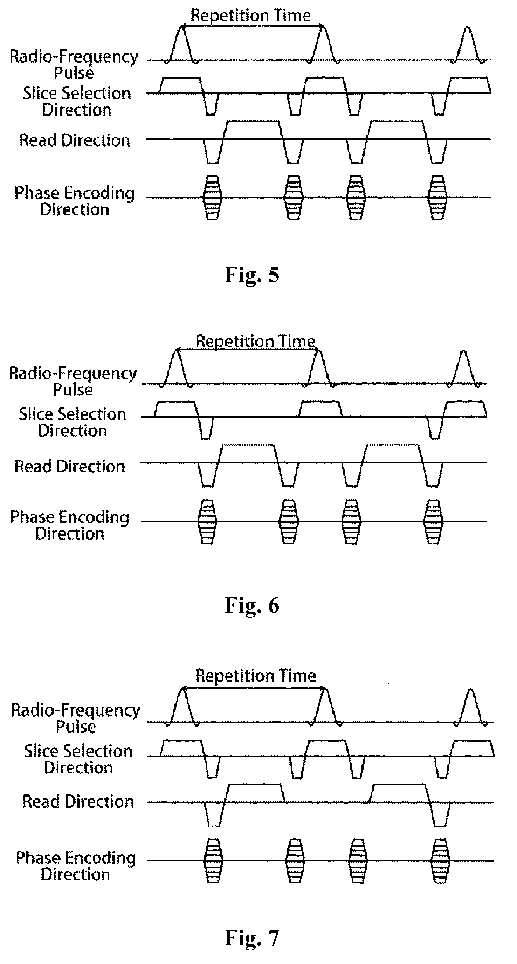

According to another embodiment of the present application of the fast magnetic resonance imaging method, slice selection is removed to alternately form a steady-state free precession sequence based on the embodiment shown in **Fig. 1**. **Fig. 5** illustrates a time sequence diagram of balanced steady-state free precession imaging sequence, within which all gradients are balanced, and the acquired signal is a complete overlapping of the FID and FISP_echo signal. **Fig. 6** is a time sequence diagram in which the compensation gradient is removed along the slice selection direction.

According to another embodiment of the present application of the fast magnetic resonance imaging method based on the embodiment shown in **Fig. 1**, the compensation gradient is removed along the frequency encoding direction (also called the readout direction) to form the alternative steady-state free precession sequence as illustrated in **Fig. 7**.

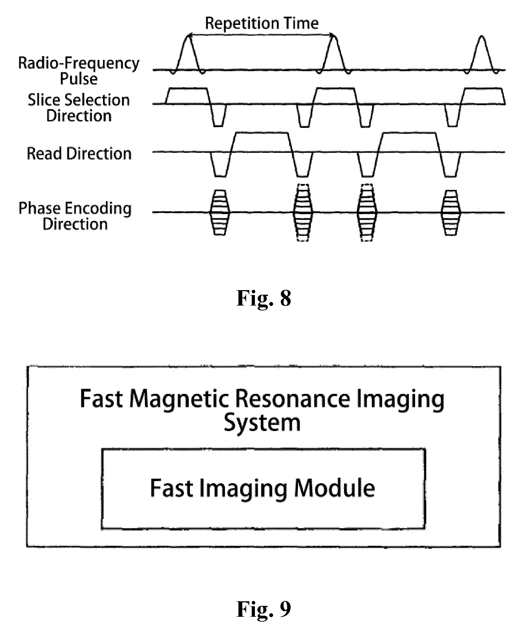

According to another embodiment of the present application of the fast magnetic resonance imaging method based on the embodiment shown in **Fig. 1**, a gradient crusher is added along the phase encoding direction to form the alternative steady-state free precession sequence as illustrated in **Fig. 8**.

Alternative steady-state free precession sequences may be formed by the methods of removing compensation gradients along the slice selection direction; removing compensation gradients along the frequency encoding direction; adding a gradient crusher along the phase encoding direction, or any combination thereof of the two or three methods illustrated above.

**Fig. 9** is a block diagram illustrating the architecture of a fast magnetic resonance imaging system according to one embodiment of the present application, comprising a fast imaging module which is configured to apply a periodic radio-frequency pulse train to drive the magnetization of an imaging volume to steady state, acquire an FID signal and an echo signal alternately in a steady-state free precession sequence, and conduct FID signal imaging and T2-weighted imaging.

According to one embodiment of the present application, the fast imaging module is further configured to acquire an FID signal and an echo signal alternately in a steady-state free precession sequence by either removing part of the compensation gradient alternately, or adding a gradient crusher in the balanced steady-state free precession sequence.

According to one embodiment of the present application, the fast imaging module is further configured to remove the compensation gradient before the next radio-frequency pulse when acquiring an FID signal and remove the compensation gradient after the radio-frequency pulse when acquiring an echo signal.

According to one embodiment of the present application, the fast imaging module is further configured to remove a compensation gradient along the slice selection direction or remove a compensation gradient along the frequency encoding direction within a balanced steady-state free precession sequence.

According to one embodiment of the present application, the fast imaging module is further configured to add a gradient crusher along the phase encoding direction.

The above is a detailed description with reference to specific embodiments of the present application. To a person of ordinary skill in the art, and without departing from the spirit or concept of the present application, various simple developments or alternations may be made. Therefore, the present application is not limited to the embodiments listed in this disclosure, but defined by the appended claims.

**Claims**

1. A method for fast magnetic resonance imaging, comprising:

   applying a periodic radio-frequency pulse train to drive magnetization vector of an imaging volume into a steady state;
   acquiring an FID signal and an echo signal in a steady-state free precession sequence alternately;
   conducting an FID signal imaging and a T2-weighted imaging.

2. The method according to claim 1, wherein the acquiring the FID signal and the echo signal in a steady-state free precession sequence alternately is by removing a part of a compensation gradient from, and/or adding a gradient crusher into a balanced steady-state free precession sequence.

3. The method according to claim 2, said the removing the part of the compensation gradient from the balanced steady-state free precession sequence, comprising:

removing the compensation gradient before a next radio-frequency pulse when acquiring the FID signal;
removing the compensation gradient after a present radio-frequency pulse when acquiring the echo signal.

4. The method according to claim 2 or 3, the removing the part of the compensation gradient from the balanced steady-state free precession sequence, comprising:

removing the compensation gradient along a slice selection direction and/or a phase encoding direction from the balanced steady-state free precession sequence.

5. The method according to claim 2, the adding the gradient crusher into the balanced steady-state free precession sequence, comprising:

adding the gradient crusher along the phase encoding direction.

6. A system for fast magnetic resonance imaging, comprising a fast imaging module configured to:

drive magnetization vector of an imaging volume into a steady state;
acquire an FID signal and an echo signal in a steady-state free precession sequence alternately; and
conduct an FID signal imaging and aT2-weighted imaging.

7. The system according to claim 6, wherein the fast imaging module is further configured to remove a part of a compensation from, and/or add a gradient crusher into a balanced steady-state free precession sequence, to acquire the FID signal and the echo signal in the steady-state free precession sequence alternately.

8. The system according to claim 7, the fast imaging module is further configured to remove the compensation gradient before a next radio-frequency pulse, when acquiring the FID; and remove the compensation gradient after a present radio-frequency pulse when acquiring the echo signal.

9. The system according to claim 7 or 8, the fast imaging module is further configured to remove the compensation gradient along a slice selection direction and/or a phase encoding direction in the balanced steady-state free precession sequence.

10. The system according to claim 7, the fast imaging module is further configured to add the gradient crusher along the phase encoding direction.

Applying a periodic radio-frequency pulse train
to drive the magnetization vector of an
imaging volumn to a steady state

102

Alternately acquiring a free induction
decay (FID) signal and an echo signal in a
steady-state free precession sequence

104

Conducting FID signal imaging and
T2-weighted imaging

106

**Fig. 1**

Repetition Time

Radio-frequency
Pulse

Slice Selection
Direction

Read Direction

Phase Encoding
Direction

**Fig. 2**

**Fig. 3**

**Fig. 4**

**Fig. 5**

**Fig. 6**

**Fig. 7**

Repetition Time

Radio-Frequency
Pulse

Slice Selection
Direction

Read Direction

Phase Encoding
Direction

**Fig. 8**

Fast Magnetic Resonance Imaging
System

Fast Imaging Module

**Fig. 9**

# INTERNATIONAL SEARCH REPORT

| International application No. |
| --- |
| PCT/CN2013/073455 |

**A.  CLASSIFICATION OF SUBJECT MATTER**

See the extra sheet

According to International Patent Classification (IPC) or to both national classification and IPC

**B.    FIELDS SEARCHED**

Minimum documentation searched (classification system followed by classification symbols)

IPC: A61B 5/-; G01R 33/-

Documentation searched other than minimum documentation to the extent that such documents are included in the fields searched

Electronic data base consulted during the international search (name of data base and, where practicable, search terms used)

CNPAT, WPI, EPODOC, CNKI: MR, steady, FID, echo, altemat+, zhong yaozu, zhu yanjie, liu xin, zheng hairong, magnetic resonance, attenuation, fast, shenzhen institute of advanced technology

**C.   DOCUMENTS CONSIDERED TO BE RELEVANT**

| Category* | Citation of document, with indication, where appropriate, of the relevant passages | Relevant to claim No. |
| --- | --- | --- |
| E | CN 103278786 A (SHENZHEN INSTITUTE OF ADVANCED TECHNOLOGY, CHINESE ACADEMY OF SCIENCES) 04 September 2013 (04.09.2013) claims 1-10 | 1-10 |
| X | US 2012/0242334 A1 (UNIVERSITY HOSPITAL OF BASEL) 27 September 2012 (27.09.2012) description, paragraphs [0045]-[0049], and figures 1 and 2 | 1, 6 |
| X | CN 1421179 A (SIEMENS AKTIENGESELLSCHAFT) 04 June 2003 (04.06.2003) description, page 5, lines 1-30, and figures 1-4 | 1, 6 |
| A | CN 1499218 A (SIEMENS AKTIENGESELLSCHAFT) 26 May 2004 (26.05.2004) the whole document | 1-10 |
| A | CN 101836123 A (KONINKL PHILIPS ELECTRONICS NV) 15 September 2010 (15.09.2010) the whole document | 1-10 |

☐ Further documents are listed in the continuation of Box C.          ☒ See patent family annex.

|  |  |  |  |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 09 December 2013 (09.12.2013) | 16 January 2014 (16.01.2014) |

| Name and mailing address of the ISA<br>State Intellectual Property Office of the P. R. China<br>No. 6, Xitucheng Road, Jimenqiao<br>Haidian District, Beijing 100088, China<br>Facsimile No. (86-10) 62019451 | Authorized officer<br><br>TIAN, Hong<br><br>Telephone No. (86-10) 62412611 |
| --- | --- |

Form PCT/ISA /210 (second sheet) (July 2009)

## INTERNATIONAL SEARCH REPORT
Information on patent family members

International application No.

PCT/CN2013/073455

| Patent Documents referred in the Report | Publication Date | Patent Family | Publication Date |
|---|---|---|---|
| CN 103278786 A | 04.09.2013 | None | |
| US 2012/0242334 A1 | 27.09.2012 | US 8497680 B2 | 30.07.2013 |
| CN 1421179 A | 04.06.2003 | US 2003/0100827 A1 | 29.05.2003 |
| | | DE 10157540 A1 | 10.07.2003 |
| | | DE 10157540 B4 | 11.01.2007 |
| | | CN 1315429 C | 16.05.2007 |
| | | US 7440791 B2 | 21.10.2008 |
| CN 1499218 A | 26.05.2004 | DE 10250922 A1 | 19.05.2004 |
| | | US 2004/0140803 A1 | 22.07.2004 |
| | | US 6891373 B2 | 10.05.2005 |
| | | DE 10250922 B4 | 31.01.2008 |
| | | CN 100426003 C | 15.10.2008 |
| CN 101836123 A | 15.09.2010 | WO 2007/124244 A1 | 01.11.2007 |
| | | EP 2010932 A1 | 07.01.2009 |
| | | IN CHENP200806190 E | 14.08.2009 |
| | | JP 2009534116 A | 24.09.2009 |
| | | US 2009/0315559 A1 | 24.12.2009 |
| | | US 8076934 B2 | 13.12.2011 |
| | | JP 5117487 B2 | 16.01.2013 |

Form PCT/ISA /210 (patent family annex) (July 2009)

## INTERNATIONAL SEARCH REPORT

International application No.

PCT/CN2013/073455

Continuation of: A. CLASSIFICATION OF SUBJECT MATTER

A61B 5/055 (2006.01) i

G01R 33/56 (2006.01) i

Form PCT/ISA /210 (extra sheet) (July 2009)